# EUROPÄISCHE PATENTSCHRIFT

(11) **EP 1 604 439 B1**
(45) Veröffentlichungstag und Bekanntmachung des Hinweises auf die Patenterteilung: **06.12.2006**
(21) Anmeldenummer: 04718260.5
(22) Anmeldetag: 08.03.2004
(51) Int. Cl.: H02H 3/00

(54) **VERFAHREN UND SCHUTZEINRICHTUNG ZUR STÖRUNGSSICHEREN PARAMET RIERUNG VON ELEKTRONISCHEN BAUGRUPPEN, INSBESONDERE NIEDERSPANNUNGS-LEISTUNGSSCHALTERN**
METHOD AND PROTECTION DEVICE FOR THE FAIL-SAFE PARAMETERISATION OF ELECTRONIC MODULES, ESPECIALLY LOW VOLTAGE POWER SWITCHES
PROCEDE ET DISPOSITIF DE PROTECTION POUR PARAMETRER, SANS PARASITE, DES MODULES ELECTRONIQUES, NOTAMMENT DES INTERRUPTEURS DE PUISSANCE BASSE TENSION

(30) Priorität: 17.03.2003 DE 10313145
(43) Veröffentlichungstag der Anmeldung: 14.12.2005
(73) Patentinhaber: Siemens AG, 80333 München (DE)
(72) Erfinder: SCHUST, Peter, 12683 Berlin (DE); SCHILLER, Manfred, 14169 Berlin (DE); RÖHL, Wolfgang, 13503 Berlin (DE); REHAAG, Hans, 16341 Zepernick (DE); REDMANN, Ilka, 10555 Berlin (DE); PANCKE, Andreas, 13507 Berlin (DE); KRAUSS, Andreas, 10825 Berlin (DE); HOCHGRAEF, Holger, 56368 Berghausen (DE)
(86) Internationale Anmeldenummer: PCT/DE2004/000489
(87) Internationale Veröffentlichungsnummer: WO 2004/084370

(56) Entgegenhaltungen:
- US-A- 4 945 443
- US-A- 5 101 316
- US-B1- 6 459 629

## Beschreibung

Die Erfindung betrifft ein Verfahren und eine Schutzeinrichtung zur störungssicheren Parametrierung von elektronischen Baugruppen mit einem Mikroprozessor mit mindestens einem nichtflüchtigen und einem flüchtigen Speicher, einer Schnittstelle zur Eingabe von Daten und einem Eingabeport, über den ein Befehl eingegeben werden kann, der die Parametrierung sperrt oder erlaubt, insbesondere für Niederspannungs-Leistungsschalter.

Haben elektrische oder elektronische Baugruppen, insbesondere Niederspannungs-Leistungsschalter, in Kundenanlagen einen Ausfall durch Beschädigung oder müssen bestimmte Schalterparameter aus anderen Gründen geändert werden, so können einzelne Teile der Leistungsschalter zwar mechanisch ersetzt werden, baugruppen- beziehungsweise schalterspezifische Informationen, welche sich nichtflüchtig in elektronisch programmierten Bauelementen befinden, sind nachträglich jedoch nicht ohne weiteres änderbar. Gleiches gilt für baugruppenspezifische Informationen in anderen Mikrocontroler gesteuerten Zubehörgeräten, insbesondere für Schaltanlagen, die allgemein als Kommunikationsgeräte, Gateways oder unter ähnlichen Bezeichnungen bekannt sind.

Es ist bekannt, solche Baugruppen mit Kommunikationsschnittstellen auszustatten. Eine Modifikation sicherheitsrelevanter Parameter wird jedoch aus Sicherheitsgründen durch entsprechende Sicherheitsseinrichtungen hardwaremäßig verhindert.

Das Setzen eines Schutzports, über den mit einem Befehl eines Mikroprozessors eine Parametrierung erlaubt oder gesperrt werden kann, ist beispielsweise aus der US-B1 6 459 629 bekannt.

Es ist auch bekannt, die Veränderung von Parametern über eine softwaremäßige Identifikationskontrolle zuzulassen. So ist aus der DE 44 45 079 A1 bekannt, an der Bedienfront des Überstromauslösers eines Niederspannungs-Leistungsschalters eine Tastatur zur Eingabe von Authentizitätsmerkmalen einer Bedienperson anzuordnen. Nach erfolgter Identifizierung ist die Parametereingabe über eine Schnittstelle möglich. Eine gleiche Anordnung ist auch aus der US-A 4 945 443 bekannt.

Eine softwaremäßige Identifikationskontrolle hat jedoch den Nachteil, dass durch ein unerwünschtes Einstellen des Programmpointers, beispielsweise durch Störungen wie elektromagnetische Einstreuungen, eine Freigabe der Parametrierungsmöglichkeit erfolgen kann, die nachfolgend, wenn vielleicht auch unbeabsichtigt, zu einer Parametrierung mit unzulässigen Werten führt. Es ist deshalb auf die oben bereits erwähnte hardwaremäßige Sicherheitseinrichtung zurückgegriffen worden.

Eine solche Sicherheitseinrichtung ist lediglich im geöffneten Gerätezustand deaktivierbar. Sicherheitsrelevante Parameter beziehungsweise Einstellungen sind dann von Unberechtigten generell nicht veränderbar.

Beispielsweise ist nach der DE 198 20 173 C1 eine Überwachungsschaltung vorgesehen, die bei Vorhandensein einer galvanischen Verbindung zwischen dem Auslösemagneten und einem vom Schalter abnehmbaren Überstromauslöser einen Sperrbefehl für die Parametrierung ausgibt, so dass eine Parametrierung am Überstromauslöser nur nach dessen Ausbauen möglich ist. Zum Ausbauen ist eine Plombe zu lösen. Eine ähnliche Maßnahme ist alternativ auch in der bereits oben genannten US-A 4 945 443 vorgesehen.

Für andere Geräte ist das Stecken eines Verbinders zum Ausschalten der Sicherheitseinrichtung bekannt, was aber wiederum nur am geöffneten Gerät vorgenommen werden kann. Das Öffnen kann nur beim Hersteller im Prüffeld erfolgen. Zur Vornahme von Änderungen müssen die betreffenden Geräte dann zum Hersteller zurückgeschickt werden, wo ein Ausbau und eine Deaktivierung der Sicherheitseinrichtung stattfinden kann und dann die entsprechenden Änderungen von Parametern beziehungsweise Einstellungen über die Kommunikationsschnittstelle vorgenommen werden. Nachfolgend erfolgen der lieferfähige Wiedereinbau der Komponenten in die jeweilige Baugruppe sowie eine Prüfung im Prüffeld und abschließend die Rücklieferung an den Kunden. Diese Vorgehensweise ist aufgrund ihrer hohen Zeit- und Kostenintensivität sehr unwirtschaftlich.

Der Erfindung liegt die Aufgabe zugrunde, ein Verfahren und eine Schutzeinrichtung zur störungssicheren Parametrierung, insbesondere für Niederspannungs-Leistungsschalter, anzugeben, welche sich durch eine höhere Wirtschaftlichkeit, als bisher bekannt, auszeichnen, ohne die Möglichkeit einer fehlerhaften Freigabe der Parametrierung durch den Mikroprozessor zuzulassen.

Diese Aufgabe wird erfindungsgemäß durch ein Verfahren und eine Schutzeinrichtung mit den in den Ansprüchen 1 und 3 genannten Merkmalen gelöst. Zweckmäßige Ausgestaltungen sind Gegenstand der Unteransprüche. Danach wird
- über die Schnittstelle ein Teilprogramm in den flüchtigen Speicher geladen,
- durch Abarbeiten des hinzugeladenen Teilprogramms eine mit dem Eingabeport verbundene Signalgabeeinrichtung von dem das Sperren der Parametrierung signalisierenden Zustand in den die Parametrierung erlaubenden Zustand umgesteuert,
- und mittels einer Registrierung des Zustandes des Eingabeports durch den Mikroprozessor die Parametrierung freigegeben.

Der erste Zustand der Signalgabeeinrichtung (Freigabe) ist beispielsweise als HIGH-Pegel, der zweite Zustand (Sperren) beispielsweise als LOW-Pegel der Signalgabeeinrichtung realisierbar. Durch die erfindungsgemäßen Mittel wird vorteilhaft ein Umgehen der Sicherheitsfunktionen nur durch die Nutzung der Schnittstelle ermöglicht. Aufgaben des Service können vor Ort zum Abschluss gebracht werden, wobei der Leistungsschalter in der Kundenanlage verbleiben kann. Somit ist kein temporärer Ausbau, Ersatz und Transport des Leistungsschalters erforderlich, wodurch eine höhere Wirtschaftlichkeit, als bisher bekannt, erzielt wird. Weiterhin werden durch den Einsatz der erfindungsgemäßen Schutzeinrichtung eine hohe Flexibilität und einfache Handhabbarkeit in Bezug auf eine Erweiter- und Modifizierbarkeit des Leistungsschalters erreicht. So ist beispielsweise auch eine sichere Änderungsmöglichkeit der Systemsoftware mit den erfindungsgemäßen Mitteln realisierbar.

Das Einlesen des Teilprogramms erfolgt über die Schnittstelle des Mikroprozessors mittels eines computerlesbaren Mediums, beispielsweise ein PC oder ein PDA.

In einer bevorzugten Ausgestaltung der Erfindung ist vorgesehen, dass die Signalgabeeinrichtung eine interne Spannungsquelle und eine interne, steuerbare Schaltvorrichtung umfasst, wobei die steuerbare Schaltvorrichtung vorzugsweise ein Transistor oder dergleichen ist. Hierdurch wird vorteilhaft eine besonders einfache Realisierbarkeit der Signalgabeeinrichtung erzielt.

Fernerhin ist vorgesehen, dass der Ausgang der Signalgabeeinrichtung über ein Pin mit einer externen Signalgabeeinrichtung verbunden ist. Hierdurch wird vorteilhaft eine besonders einfach handhabbare und schnelle Deaktivierbarkeit der Sicherheitsfunktion zum Einschreiben geschützter Informationen in den Mikroprozessor erzielt, welche insbesondere in der Fertigung oder dem Prüffeld genutzt werden kann.

Die externe Signalgabeeinrichtung umfasst ebenfalls eine Spannungsquelle und ein Schaltmittel, wobei das Schaltmittel in diesem Fall vorzugsweise eine Drahtbrücke ist. Hierdurch werden eine besonders einfache Realisierbarkeit und Handhabbarkeit der Signalgabeeinrichtung erzielt.

Vorzugsweise erfolgt eine abschließende Deaktivierung des Teilprogramms nach seiner Abarbeitung und den entsprechenden vorgenommenen Parameteränderungen durch Löschen des Teilprogramms mit einem wiederum über die Schnittstelle eingegebenen Befehl.

Durch die Deaktivierung des Teilprogramms wird wieder der ursprüngliche Zustand der Signalgabeeinrichtung erzeugt und mittels der Registrierung dieses Zustandes wird durch den Mikroprozessor die weitere Parametrierung blockiert.

Das Teilprogramm ist ohne ein Hineinlesen über die Schnittstelle nicht generierbar, somit kann dieses nie durch ein unerwünschtes Einstellen des Programmpointers, beispielsweise durch Störungen wie elektromagnetische Einstreuungen, abgearbeitet werden.

Die Erfindung wird nachfolgend anhand eines Ausführungsbeispiels näher erläutert. In den zugehörigen Zeichnungen zeigen:
- Figur 1: eine Schutzeinrichtung in der Fertigung;
- Figur 2: eine Schutzeinrichtung in der Anwendung im blockierenden Zustand;
- Figur 3: eine Schutzeinrichtung in der Anwendung im freigebenden Zustand vor Ort und
- Figur 4: ein Flussdiagramm zur Arbeit des Mikroprozessors nach dem erfindungsgemäßen Verfahren.

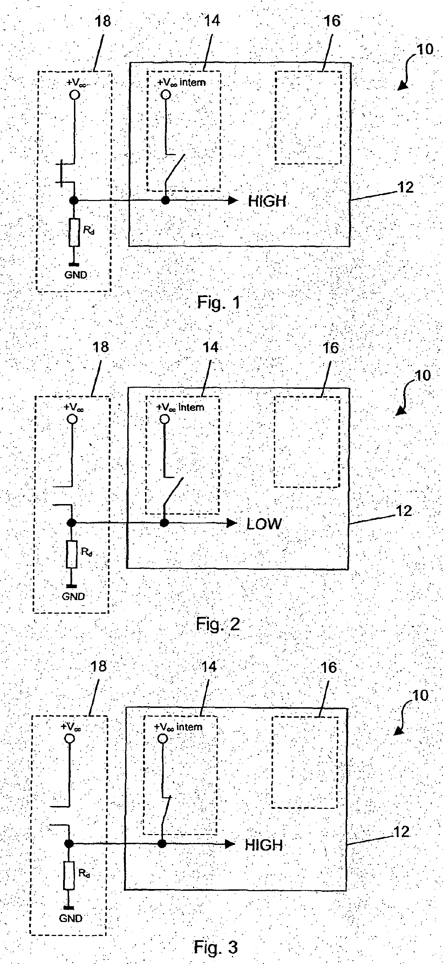

Figur 1 zeigt eine Ausführung einer erfindungsgemäßen Schutzeinrichtung 10 mit einem Mikroprozessor 12, einer Signalgabeeinrichtung 14 und einer seriellen Schnittstelle 16 im Einsatz in der Fertigung. Die Signalgabeeinrichtung 14 umfasst eine interne Spannungsquelle V_{CCintern} und einen mit dieser verbundenen, mittels des Mikroprozessors 12 ansteuerbaren Schalter. Weiterhin umfasst die Schutzeinrichtung 10 eine externe Signalgabeeinrichtung 18, welche ebenfalls eine Spannungsquelle V_{CC} sowie ein mit dieser verbundenes Schaltmittel umfasst, welches in Form zweier offener elektrischer Kontakte ausgebildet ist. Der Ausgang der externen Signalgabeeinrichtung 18 ist parallel zu dem Ausgang der Signalgabeeinrichtung 14 geschaltet, so dass das Potential beider Ausgänge durch den Mikroprozessor 12 registrierbar ist.

Im Rahmen der Fertigung erfolgt ein Kurzschluss der beiden Kontakte mittels einer Drahtbrücke. Das Potential am Ausgang der externen Signalgabeeinrichtung 18 wird somit auf das Potential der Spannungsquelle V_{CC} der externen Signalgabeeinrichtung 18 gezogen. Der Mikroprozessor 12 registriert auf diese Weise einen HIGH-Pegel des Ausgangs, wodurch eine Änderung von Parametern beziehungsweise ein Einschreiben von Informationen in den Mikroprozessor 12 freigegeben wird. Wird die Drahtbrücke entfernt, fällt das Potential am Ausgang der externen Signalgabeeinrichtung 18 wieder auf einen LOW-Pegel. Sobald eine Registrierung des LOW-Pegels mittels des Mikroprozessors 12 erfolgt, werden weitere Parameter- beziehungsweise Informationsänderungen blockiert. Die Schutzeinrichtung 10 befindet sich nun im geschützten Zustand.

Mittels eines über die Schnittstelle 16 in den flüchtigen Speicher des Mikroprozessors 12 eingebrachten Teilprogramms ist nun die Änderung des Zustandes der Signalgabeeinrichtung 14 ebenfalls möglich. Wie in Figur 2 und Figur 3 dargestellt, erfolgt die Freigabe von Parameteränderungen beziehungsweise Einschreibvorgängen von Informationen mittels der in den Mikroprozessor 12 integrierten Signalgabeeinrichtung 14. Der Schalter der Signalgabeeinrichtung 14 in Figur 2 befindet sich im offenen Zustand, so dass das Potential am Ausgang der Signalgabeeinrichtung 14 zunächst einen LOW-Pegel aufweist. Dieser wird vom Mikroprozessor 12 registriert, wodurch Parameteränderungen beziehungsweise ein Einschreiben von Informationen blockiert sind. Somit wird ein Überschreiben von geschützten Informationen verhindert. Mit Hilfe der Abarbeitung eines temporär über die Schnittstelle 16 in den flüchtigen Speicher des Mikroprozessors 12 eingebrachten Teilprogramms ist der Schalter der Signalgabeeinrichtung 14 schließbar, so dass der Pegel am Ausgang der Signalgabeeinrichtung 14 auf den Pegel der Spannungsquelle V_{CCintern} der Signalgabeeinrichtung 14 gezogen wird. Der Mikroprozessor 12 registriert somit einen HIGH-Pegel an dem Ausgang, wodurch eine Freigabe von Parameteränderungen beziehungsweise Einschreibvorgängen von Informationen erfolgt.

Nach Beendigung der Modifikation erfolgt eine Löschung des Teilprogramms durch Befehlsgabe über die Schnittstelle, wodurch der Schalter der Signalgabeeinrichtung 14 wieder in den geöffneten Zustand gebracht wird. Deren Ausgang weist nun einen LOW-Pegel auf, wodurch wieder der in Figur 2 gezeigte Zustand der Schutzeinrichtung 10 eingenommen wird und die im Mikroprozessor 12 gespeicherten Informationen gegen Änderungen geschützt sind. Die Schutzeinrichtung 10 befindet sich somit wieder im sicheren Ausgangszustand. Mittels der erfindungsgemäßen Schutzeinrichtung 10 kann ein hoher Sicherheitsstandard eingehalten werden. Eine zufällige Deaktivierung der Sicherheitsfunktionen, beispielsweise durch elektromagnetische Störfelder, ist nicht möglich.

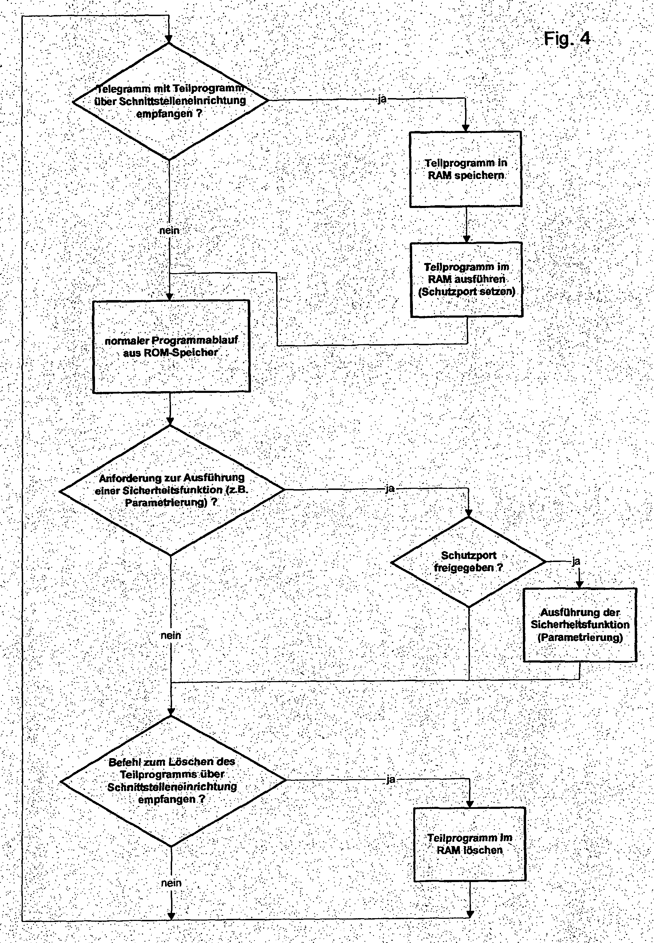

In Figur 4 ist der Programmablauf im Mikroprozessor 12 bei einer beabsichtigten Parametrierung dargestellt. Der Mikroprozessor 12 prüft regelmäßig über sein in einem ROM gespeicherten Programm ob die Anforderung nach einer Parametrierung ansteht. Soll eine Parametrierung erfolgen, wird über die serielle Schnittstelle 16 ein Telegramm mit einem externen Teilprogramm eingelesen und in einem flüchtigen RAM-Speicher abgelegt. Der RAM-Speicher beginnt unmittelbar nach dem Einlesen mit der Abarbeitung des Programms, das heißt er bewirkt das Schließen des Schalters der Signalgabeeinrichtung 14.

Damit wird der Ausgang der Signalgabeeinrichtung 14, gleichzeitig Eingang des Schutzports des Mikroprozessors 12, auf HIGH-Pegel gesetzt. Liest das Programm jetzt, dass der Schutzport auf HIGH gesetzt ist, wird die Parametrierung freigegeben.

Würde dagegen das Setzen des Schutzports im Hauptprogramm fest programmiert sein, das sich im ROM-Speicher befindet, was bei der bekannten Identifikationskontrolle analog zu DE 44 45 079 A1 der Fall wäre, wäre es möglich, dass durch elektromagnetische Einstreuungen ein unerwünschtes Setzen des Schutzports erfolgen könnte.

Nach dem Beenden des Parametrierens wird das Teilprogramm - wie oben bereits beschrieben - wieder gelöscht.

## Patentansprüche

1. Verfahren zur störungssicheren Parametrierung von elektronischen Baugruppen mit einem Mikroprozessor mit mindestens einem nichtflüchtigen und einem flüchtigen Speicher, einer Schnittstelle zur Eingabe von Daten und einem Eingabeport, über den ein Befehl eingegeben werden kann, der die Parametrierung sperrt oder erlaubt, insbesondere für Niederspannungs-Leistungsschalter, **wobei**
- über die Schnittstelle ein Teilprogramm in den flüchtigen Speicher geladen wird,
- durch Abarbeiten des hinzugeladenen Teilprogramms eine mit dem Eingabeport verbundene Signalgabeeinrichtung von dem das Sperren der Parametrierung signalisierenden Zustand in den die Parametrierung erlaubenden Zustand umgesteuert wird,
- und mittels einer Registrierung des Zustandes des Eingabeports durch den Mikroprozessor eine Parametrierung freigegeben wird.

2. Verfahren nach Anspruch 1, **dadurch gekennzeichnet, dass** das Teilprogramm nach dem Beenden der Parametrierung deaktiviert wird.

3. Schutzeinrichtung zur störungssicheren Parametrierung von elektronischen Baugruppen mit einem Mikroprozessor mit mindestens einem nichtflüchtigen und einem flüchtigen Speicher, einer Schnittstelle zur Eingabe von Daten und einem Eingabeport, über den ein Befehl eingegeben werden kann, der die Parametrierung sperrt oder erlaubt, insbesondere für Niederspannungs-Leistungsschalter, **gekennzeichnet durch** eine **durch** den Mikroprozessors (12) ansteuerbare Signalgabeeinrichtung (14), deren Ausgang mit dem Eingabeport verbunden ist und die **durch** Abarbeiten eines über die Schnittstelle in den flüchtigen Speicher des Mikroprozessors (12) hinzugeladenen Teilprogramms von dem das Sperren der Parametrierung signalisierenden Zustand in den die Parametrierung erlaubenden Zustand umsteuerbar ist.

4. Schutzeinrichtung nach Anspruch 3, **dadurch gekennzeichnet, dass** die Signalgabeeinrichtung (14) eine Spannungsquelle umfasst.

5. Schutzeinrichtung nach Anspruch 3 oder 4, **dadurch gekennzeichnet, dass** die Signalgabeeinrichtung (14) eine steuerbare Schaltvorrichtung umfasst.

6. Schutzeinrichtung nach Anspruch 5, **dadurch gekennzeichnet, dass** die steuerbare Schaltvorrichtung ein Transistor ist.

7. Schutzeinrichtung nach einem der Ansprüche 3 bis 6, **dadurch gekennzeichnet, dass** sie eine externe Signalgabeeinrichtung (18) umfasst, die mit dem Eingabeport verbunden ist.

8. Schutzeinrichtung nach Anspruch 7, **dadurch gekennzeichnet, dass** die externe Signalgabeeinrichtung (18) eine Spannungsquelle umfasst.

9. Schutzeinrichtung nach Anspruch 8, **dadurch gekennzeichnet, dass** die externe Signalgabeeinrichtung (18) ein Schaltmittel umfasst.

10. Schutzeinrichtung nach Anspruch 9, **dadurch gekennzeichnet, dass** das Schaltmittel eine Drahtbrücke ist.

## Claims

1. Method for interference-proof parameterization of electronic modules having a microprocessor having at least one non-volatile and one volatile memory, an interface for the input of data and an input port, via which a command can be input that inhibits or allows parameterization, in particular for low-voltage power switches, wherein
- a subroutine is loaded in the volatile memory via the interface
- by execution of the additionally loaded subroutine, a signalling device connected to the input port is switched from the state signalling that parameterization is inhibited into the state allowing parameterization,
- and by means of registering the state of the input port by the microprocessor, parameterization is enabled.

2. Method according to Claim 1, **characterized in that** the subroutine is disabled after parameterization is complete.

3. Protective device for interference-proof parameterization of electronic modules having a microprocessor having at least one non-volatile and one volatile memory, an interface for the input of data and an input port, via which a command can be input that inhibits or allows parameterization, in particular for low-voltage power switches, **characterized by** a signalling device (14) that can be controlled by the microprocessor (12), the output of said signalling device being connected to the input port and, by execution of a subroutine additionally loaded into the volatile memory of the microprocessor (12) via the interface, said signalling device can be switched from the state signalling that parameterization is inhibited into the state allowing parameterization.

4. Protective device according to Claim 3, **characterized in that** the signalling device (14) comprises a voltage source.

5. Protective device according to Claim 3 or 4, **characterized in that** the signalling device (14) comprises a controllable switching device.

6. Protective device according to Claim 5, **characterized in that** the controllable switching device is a transistor.

7. Protective device according to any of Claims 3 to 6, **characterized in that** it comprises an external signalling device (18), which is connected to the input port.

8. Protective device according to Claim 7, **characterized in that** the external signalling device (18) comprises a voltage source.

9. Protective device according to Claim 8, **characterized in that** the external signalling device (18) comprises a switching means

10. Protective device according to Claim 9, **characterized in that** the switching means is a wire jumper.

## Revendications

1. Procédé de paramétrage déparasité de modules électroniques, au moyen d'un microprocesseur comportant au moins une mémoire non volatile et une mémoire volatile, une interface d'entrée de données et un port d'entrée permettant d'entrer une instruction qui interdit ou autorise le paramétrage, ledit procédé étant notamment destiné à des disjoncteurs basse tension,
- un sous-programme étant chargé par le biais l'interface dans la mémoire volatile,
- un dispositif de délivrance de signal, relié au port d'entrée, étant commandé en exécutant le sous-programme chargé pour passer de l'état signalant l'interdiction du paramétrage dans l'état autorisant le paramétrage, et
- un paramétrage étant autorisé par le microprocesseur en enregistrant l'état du port d'entrée.

2. Procédé selon la revendication 1, **caractérisé en ce que** le sous-programme est activé après la fin du paramétrage.

3. Dispositif de protection destiné au paramétrage déparasité des modules électroniques, ledit dispositif de protection comportant un microprocesseur comprenant au moins une mémoire non volatile et une mémoire volatile, une interface destinée à entrer des données et un port d'entrée permettant d'entrer une instruction qui interdit ou autorise le paramétrage, ledit dispositif de protection étant notamment destiné à des disjoncteurs basse tension, **caractérisé par** un dispositif de délivrance de signal (14), qui peut être commandé par le microprocesseur (12), dont la sortie est reliée au port d'entrée et qui peut être commandé en exécutant un sous-programme chargé dans la mémoire volatile du microprocesseur (12), par le biais de l'interface, pour passer de l'état signalant l'interdiction du paramétrage dans l'état autorisant le paramétrage.

4. Dispositif de protection selon la revendication 3, **caractérisé en ce que** le dispositif de délivrance de signal (14) comporte une source de tension.

5. Dispositif de protection selon la revendication 3 ou 4, **caractérisé en ce que** le dispositif de délivrance de signal (14) comporte un dispositif de commutation pouvant être commandé.

6. Dispositif de protection selon la revendication 5, **caractérisé en ce que** le dispositif de commutation pouvant être commandé est un transistor.

7. Dispositif de protection selon l'une des revendications 3 à 6, **caractérisé en ce qu'**il comporte un dispositif de délivrance de signal externe (18) qui est relié au port d'entrée.

8. Dispositif de protection selon la revendication 7, **caractérisé en ce que** le dispositif de délivrance de signal externe (18) comporte une source de tension.

9. Dispositif de protection selon la revendication 8, **caractérisé en ce que** le dispositif de délivrance de signal externe (18) comporte un moyen de commutation.

10. Dispositif de protection selon la revendication 9, **caractérisé en ce que** le moyen de commutation est un pontage à fil.
